# EUROPEAN PATENT APPLICATION

(11) **EP 3 540 397 A1**
(43) Date of publication of application: **18.09.2019**
(21) Application number: 17869151.5
(22) Date of filing: 21.08.2017
(51) Int. Cl.: G01K 7/32, H03B 5/32, H03H 9/205

(54) **TEMPERATURE DETECTION DEVICE**

(30) Priority: 14.11.2016 JP 2016221219
(71) Applicant: Nihon Dempa Kogyo Co., Ltd., Tokyo 151-8569 (JP)
(72) Inventor: KUKITA, Hiroyuki, Sayama-shi Saitama 350-1321 (JP); WAKAMATSU, Shunichi, Sayama-shi Saitama 350-1321 (JP); SHIOBARA, Tsuyoshi, Sayama-shi Saitama 350-1321 (JP); ISHIKAWA, Takayuki, Sayama-shi Saitama 350-1321 (JP)
(74) Representative: TBK
(86) International application number: PCT/JP2017/029780
(87) International publication number: WO 2018/087978

(57) **Abstract**

[PROBLEM] To provide a temperature detector without possibility of interruption in temperature detection in detecting a temperature based on a change in oscillation frequency of a crystal element.

[SOLUTION] First and second vibrating regions 40, 50 are formed on a crystal element 14, the first or the second vibrating region 40, 50 is oscillated with a third harmonic or a fundamental wave by switching switches SW1 to SW3. A data processing unit 6 obtains frequency change rates F2, F1 of the third harmonic and the fundamental wave in the first vibrating region, and detects the temperature from a difference between them. Further, whether the oscillation of the first vibrating region 40 is abnormal is monitored based on the measurement result of the frequency of the first vibrating region 40, and when the abnormality is determined, the temperature is detected from similar difference (F2' - F1') using the second vibrating region 50.

## Description

### TECHNICAL FIELD

The present invention relates to a temperature detector using a crystal resonator.

### BACKGROUND ART

An oscillator using a crystal resonator is employed at, for example, a base station and a relay station that performs communication with a mobile terminal, or a base station and a relay station that transmits image data to a digital television, and required to perform stable oscillation against environmental temperature change. In view of this, for example, an Oven Controlled Crystal Oscillation (OCXO) is used, but it is necessary to generate a signal accurately corresponding to a temperature of an atmosphere where the oscillator is placed for supplying electric power of a heater with high accuracy. When a Temperature Compensated Crystal Oscillation (TCXO) is used, it is necessary to generate a signal accurately corresponding to a temperature for compensating a set voltage supplied to a circuit including a crystal resonator.

Furthermore, in a manufacturing process of a semiconductor device, equipment for forming a coating film with a chemical liquid such as a resist and equipment for performing a heating process on the coating film are used. This type of equipment is required to accurately measure a temperature of treatment atmosphere in an aspect of accurately controlling an in-plane uniformity of a film thickness of the coating film because of, for example, development of a three-dimensional device.

However, a wide temperature range as a measurement target causes what is called a frequency jump of an oscillation frequency of the crystal resonator especially in a high temperature region or a low temperature region, thus the measurement possibly become impossible.

Patent Document 1 discloses a technique where a crystal resonator includes two pairs of electrodes to form two vibrating regions, a difference in frequency or a difference in change rate of the frequency relative to a reference temperature is detected for a third higher harmonic (third harmonic of a fundamental wave) in one vibrating region and a third higher harmonic in the other vibrating region, and the detected value is used as the temperature of the crystal resonator. However, there has not been considered for the possibility to cause a trouble where the occurrence of the frequency jump interrupts the temperature measurement, thus causing fluctuation in the oscillation frequency.

Patent Document 2 discloses a technique where one crystal resonator is used to measure change in resonance frequency for each of two modes of vibration, and the change is used as the temperature change. However, it is not a technique enough to eliminate the above-described possibility.

### CITATION LIST

### Patent Document

Patent Document 1: Japanese Unexamined Patent Application Publication No. 2012-170050
Patent Document 2: Japanese Unexamined Patent Application Publication No. 2004-184256

### DISCLOSURE OF THE INVENTION

### PROBLEMS TO BE SOLVED BY THE INVENTION

The present invention has been made under these circumstances, and it is an object of the present invention to provide a temperature detector without possibility of interruption in temperature detection in detecting a temperature based on a change in oscillation frequency of a crystal element.

### SOLUTIONS TO THE PROBLEMS

The present invention includes a first vibrating region, a second vibrating region, a fundamental wave oscillator circuit, a harmonic oscillator circuit, a frequency measurement unit, a switch, and a data processing unit. The first vibrating region is sandwiched between first electrodes. The respective first electrodes are disposed on one surface side and another surface side of a crystal element. The second vibrating region is sandwiched between second electrodes. The respective second electrodes are disposed on the one surface side and the other surface side of the crystal element. The fundamental wave oscillator circuit oscillates the first vibrating region or the second vibrating region with a fundamental wave. The harmonic oscillator circuit oscillates the first vibrating region or the second vibrating region with a higher harmonic. The frequency measurement unit measures an oscillation frequency of the fundamental wave oscillator circuit or the harmonic oscillator circuit. The switch is configured to select any of states. The states includes a state where the first electrodes are connected to the frequency measurement unit via the fundamental wave oscillator circuit, a state where the first electrodes are connected to the frequency measurement unit via the harmonic oscillator circuit, a state where the second electrodes are connected to the frequency measurement unit via the fundamental wave oscillator circuit, and a state where the second electrodes are connected to the frequency measurement unit via the harmonic oscillator circuit. The data processing unit is configured to output a switch signal of the switch, obtain a difference between a frequency change rate of the higher harmonic in one vibrating region of the first vibrating region and the second vibrating region and a frequency change rate of the fundamental wave of the one vibrating region based on measurement result measured by the frequency measurement unit, and detect a temperature of an atmosphere from the difference. The crystal element is placed in the atmosphere. The data processing unit monitors whether the oscillation of the one vibrating region is abnormal or not based on the measurement result of the frequency of the one vibrating region. The data processing unit is configured such that the data processing unit detects the temperature of the atmosphere where the crystal element is placed from a difference between a frequency change rate of the higher harmonic in another vibrating region of the first vibrating region and the second vibrating region and a frequency change rate of the fundamental wave of the other vibrating region when the oscillation of the one vibrating region is determined to be abnormal.

### EFFECTS OF THE INVENTION

In the present invention, a pair of the first electrodes and a pair of the second electrodes are disposed on the crystal element to form the first and the second vibrating regions. The frequency change rates (rate of a change amount of the frequency from a frequency at a temperature determined as a reference temperature to the frequency at the reference temperature) in the respective oscillations of the one vibrating region with the higher harmonic, for example, the third harmonic, and the fundamental wave are obtained, and the temperature of the atmosphere where the crystal element is placed is detected from the difference between them. Then, whether the oscillation of the one vibrating region is abnormal is monitored based on the measurement result of the frequency of the one vibrating region, and when the abnormality is determined, the temperature is detected from similar difference using the other vibrating region. Accordingly, for example, even when the detection is performed over a wide temperature range, there is no possibility of interruption in the temperature detection.

### BRIEF DESCRIPTION OF THE DRAWINGS

FIG. 1 is an external view illustrating the whole temperature detector according to an embodiment of the present invention.
FIG. 2 includes plan views illustrating a front surface side of a resonator unit disposed in an oscillator circuit unit of the temperature detector.
FIG. 3 includes a plan view illustrating a front surface side and a plan view illustrating a back surface side of a crystal resonator disposed in the resonator unit.
FIG. 4 is a vertical cross-sectional view illustrating the resonator unit.
FIG. 5 is a block diagram illustrating the temperature detector.
FIG. 6 is a characteristic diagram illustrating a relation between a frequency change rate and a temperature for each of a fundamental wave and a third harmonic of the crystal resonator.
FIG. 7 is a characteristic diagram illustrating a relation between a difference between the frequency change rate of the fundamental wave and the frequency change rate of the third higher harmonic of the crystal resonator, and the temperature.
FIG. 8 is a flowchart illustrating an operational flow of the temperature detector.

### DESCRIPTION OF PREFERRED EMBODIMENTS

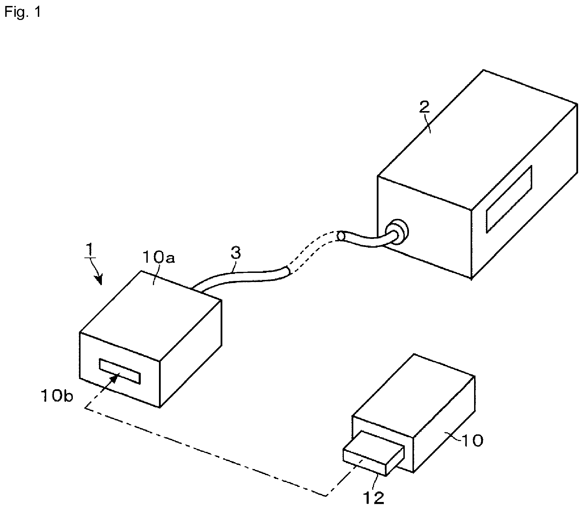

A temperature detector according to the embodiment of the present invention includes, as illustrated in FIG. 1, an oscillator circuit unit 1, a measurement unit 2, and a signal cable 3 that includes a signal path to connect the oscillator circuit unit 1 to the measurement unit 2.

In this example, the oscillator circuit unit 1 includes a main body portion 10a and a resonator unit 10 attachable/detachable to/from the main body portion 10a. FIG. 1 is an exploded perspective view illustrating a state where one end of a circuit board 12 (described below) of the resonator unit 10 is inserted into a jack 10b of the main body portion 10a.

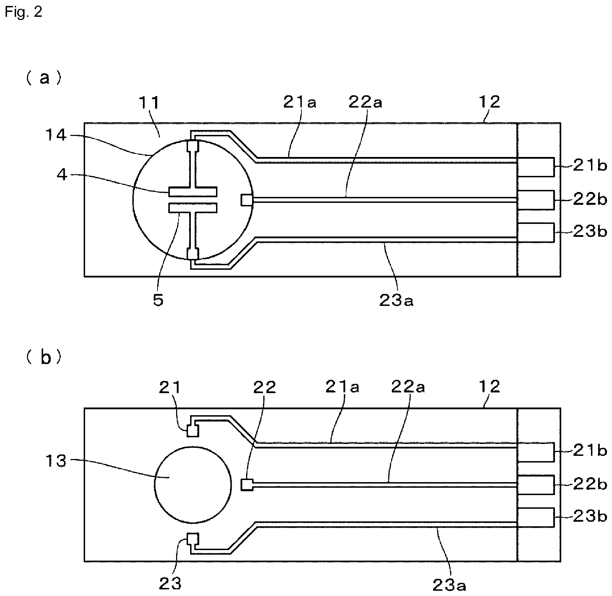

As illustrated in FIG. 2A, the resonator unit 10 includes a crystal resonator 11 and the circuit board 12 as a support body that supports the crystal resonator 11 and the circuit board 12 is made of an insulating material. FIG. 2A is a drawing illustrating the circuit board 12 to which the crystal resonator 11 is mounted viewed from the front surface side (crystal resonator 11 side), and FIG. 2B is a drawing illustrating the circuit board 12 to which the crystal resonator 11 is not mounted viewed from the front surface side. As illustrated in FIG. 2B, the circuit board 12 has another end side where an opening 13 is formed to be slightly smaller than the crystal resonator 11, and the opening 13 has a peripheral edge adjacent to which three terminal portions 21, 22, and 23 are disposed.

On the front surface side of the circuit board 12, conductive paths 21a, 22a, and 23a respectively extends from the terminal portions 21, 22, and 23 toward one end side of the circuit board 12. The conductive paths 21a, 22a, and 23a have one end sides respectively formed as connecting terminals 21b, 22b, and 23b, which are connected to respective connecting terminals on the main body portion 10a side.

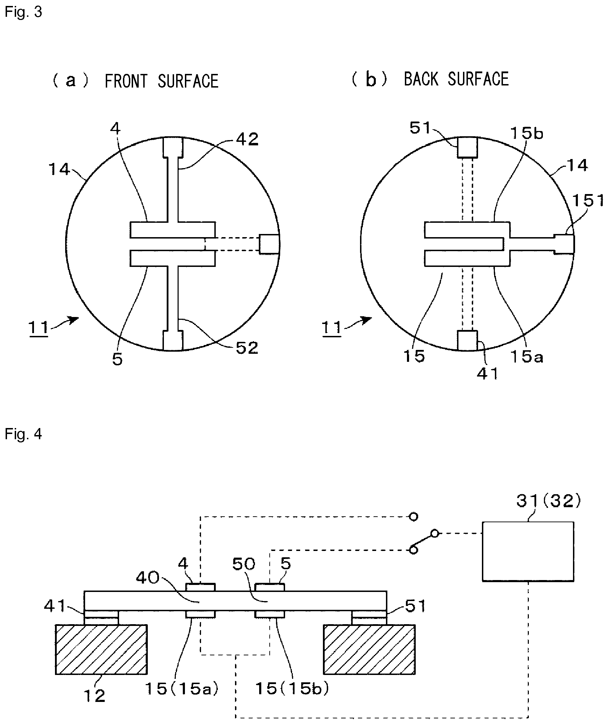

As illustrated in FIG. 3A, the crystal resonator 11 includes an AT-cut circular crystal element 14, and strip-shaped first electrode 4 and second electrode 5. The first electrode 4 and the second electrode 5 are formed across the center of this crystal element 14 separately from one another in a radial direction in parallel on one surface side of the crystal element 14. From the center of the first electrode 4 and the second electrode 5, extraction electrodes 42 and 52 extend toward an outer periphery of the crystal element 1 so as to be perpendicular to the electrodes 4 and 5. The extraction electrodes 4 and 5 are folded back to a back surface side at the outer periphery of the crystal element 1 and formed as connecting terminals 41 and 51 (see FIG. 3B).

On the other surface side of the crystal element 14, as illustrated in FIG. 3B, an other-surface-side electrode 15 is formed in a region including projection areas of the first electrode 4 and the second electrode 5. The other-surface-side electrode 15 includes strip-shaped portions 15a and 15b positioned in the respective projection areas of the first electrode 4 and the second electrode 5, and a connecting portion that connects these strip-shaped portions 15a and 15b on the one end side. The outer peripheral side of the crystal element 14 at the connecting portion is folded back, and an end portion on the back surface side is formed as a connecting terminal 151.

The first electrode 4, the second electrode 5, and the other-surface-side electrode 15 are formed as electrode films where, for example, layered gold is formed on a chromium layer as an adhesive layer. The first electrode 4 and the second electrode 5 are connected to a direct current power source side of the oscillator circuit as described below, and the other-surface-side electrode 15 is connected to an earth side of the oscillator circuit. The one end side of the circuit board 12 is inserted into the jack 10b of the main body portion 10a and mounted to the main body portion 10a, and the connecting terminals 21b, 22b, and 23b of the circuit board 12 are connected to the oscillator circuit via respective connecting terminals disposed on the main body portion 10a.

As illustrated in FIG. 4, the crystal element 14 has a region corresponding to a first vibrating region 40 sandwiched between the first electrode 4 and the portion (strip-shaped portion 15a) of the other-surface-side electrode 15 facing this first electrode 4, and the crystal element 14 has a region corresponding to a second vibrating region 50 sandwiched between the second electrode 5 and the portion (strip-shaped portion 15b) of the other-surface-side electrode 15 facing this second electrode 5. FIG. 4 is a drawing for illustrating the first vibrating region 40 and the second vibrating region 50, and for easily understanding the relationship between the crystal resonator 11 and the circuit board 12, thus FIG. 4 is not precisely illustrated as a sectional drawing.

To avoid complication of reference numerals, the electrodes on both surface sides sandwiching the first vibrating region 40 are both referred to as the first electrode 4, and the electrodes on both surface sides sandwiching the second vibrating region 50 are both referred to as the second electrode 5, in some cases.

As seen from FIG. 2A, 2B, and FIG. 3B, the connecting terminals 41, 151, and 51 on the back surface side of the crystal resonator 11 are respectively connected to the connecting terminals 21, 22, and 23 of the circuit board 12. The crystal resonator 11 is secured to the circuit board 12 at portions of the connecting terminals 41, 151, and 51 with a conductive adhesive.

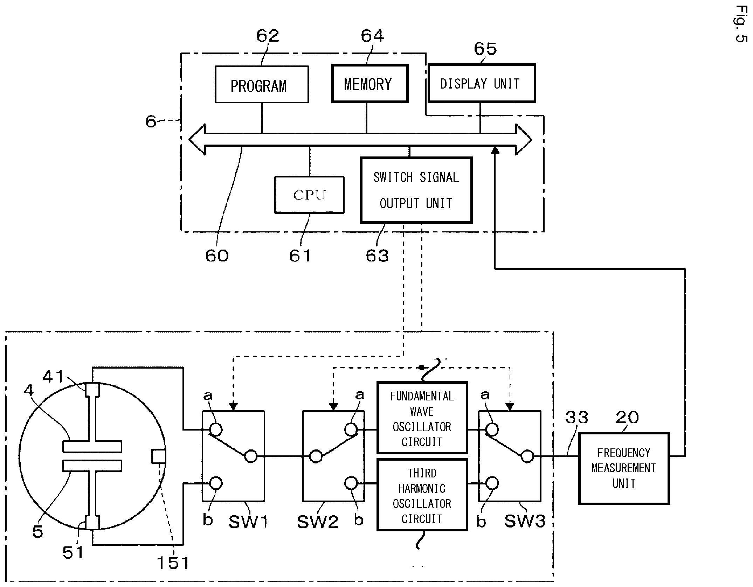

FIG. 5 is a block diagram illustrating a circuit configuration of a temperature detector of the embodiment. The oscillator circuit unit 1 includes a fundamental wave oscillator circuit 31 and a third harmonic oscillator circuit 32. The fundamental wave oscillator circuit 31 oscillates the first vibrating region 40 or the second vibrating region 50 of the crystal resonator 11 with a fundamental wave. The third harmonic oscillator circuit 32 oscillates the first vibrating region 40 or the second vibrating region 50 with a third harmonic (third higher harmonic) having a frequency three times of that of the fundamental wave.

Furthermore, the oscillator circuit unit 1 includes switches SW1 and SW2, and a switch SW3. The switches SW1 and SW2 selectively connect the first vibrating region 40 to the fundamental wave oscillator circuit 31 and the third harmonic oscillator circuit 32, and selectively connect the second vibrating region 50 to the fundamental wave oscillator circuit 31 and the third harmonic oscillator circuit 32. The switch SW3 selectively connects one and the other of the fundamental wave oscillator circuit 31 and the third harmonic oscillator circuit 32 to a frequency measurement unit 6 via a signal path 33.

Specifically, the first electrode 4 and the second electrode 5 are electrically connected to switching contacts ***a*** and ***b*** of the switch SW1, respectively. The electrode 15 on the other surface side of the crystal element 14 is earthed while wiring is not illustrated in FIG. 5. That is, the electrode 15 on the other surface side is connected to the earth sides of the fundamental wave oscillator circuit 31 and the third harmonic oscillator circuit 32.

The switches SW1, SW2, and SW3 are configured such that the connection is switched between the switching contacts ***a*** and ***b*** by a control signal from a data processing unit described below. The fundamental wave oscillator circuit 31, the third harmonic oscillator circuit 32, and the switches SW1, SW2, and SW3 are disposed in the main body portion 10a in this example.

The measurement unit 2 includes a frequency measurement unit 20 and the data processing unit 6. The frequency measurement unit 20 measures oscillation frequencies of the fundamental wave oscillator circuit 31 and the third harmonic oscillator circuit 32. The data processing unit 6 includes, for example, a computer and performs data processing based on the measurement results by this frequency measurement unit 20.

The data processing unit 6 includes a bus 60, a CPU 61, a program storage unit 62 that stores a program, a switch signal output unit 63 that outputs switch signals to the switches SW1 to SW3, and a memory 64. A display unit 65 that displays temperature and warnings is connected to the data processing unit 6.

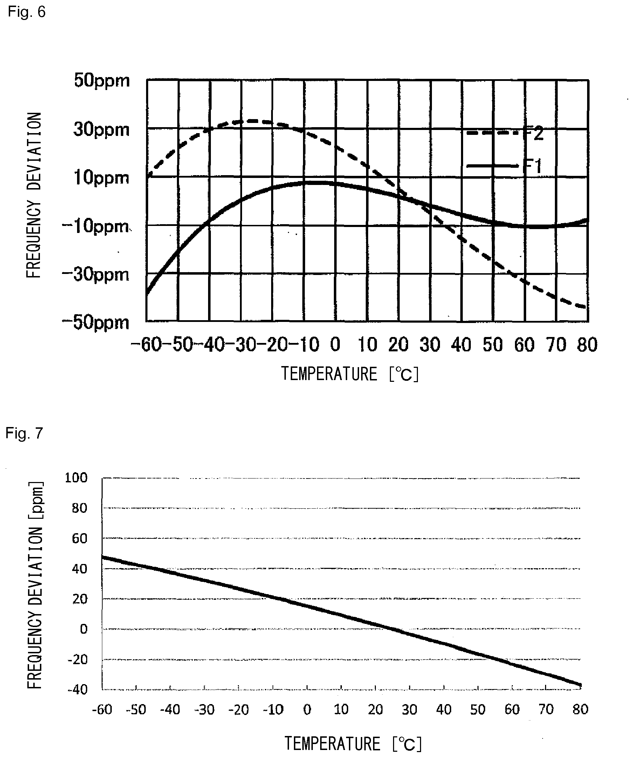

Here, frequency versus temperature characteristics of the crystal resonator 11 will be described. In this embodiment, a frequency change rate (indicated with ppm) F1 from -60°C to 80°C when the crystal element 14 is oscillated with the fundamental wave is indicated by a solid line in FIG. 6, and a frequency change rate F2 from -60°C to 80°C in the oscillation with the third harmonic is indicated by a dotted line in FIG. 6, for example. The frequency change rate is a rate of a difference between the frequency at a reference temperature, for example, 25°C and the frequency at that time to the frequency at the reference temperature. That is, when the frequency at a certain temperature is assumed to ***f***, and the frequency at the reference temperature is assumed to ***f0**,* the frequency change rate F1 or F2 (ppm) is indicated as {(***f**-**f0***)/***f0***} × 10⁶.

FIG. 7 illustrates an exemplary temperature characteristic of the difference in frequency change rate having a vertical axis indicating the difference between F1 and F2 and a horizontal axis indicating the temperature. For example, from -60°C to 80°C, the difference in frequency change rate varies linearly to the temperature. Therefore, by monitoring F1 - F2, the temperature of the crystal element 14, that is, the temperature of an atmosphere where the crystal element 14 is placed can be detected.

The switch signal output unit 63 of the data processing unit 6 has a function to output the switch signal to switch the switch SW1 to any of the switching contacts ***a*** and ***b**,* and the switch signal to simultaneously switch the switches SW2 and SW3 to any of the switching contacts ***a*** and ***b**.* The switch signal provides any state of: a state where the first electrode 4 on the one surface side of the crystal element 14 is connected to the fundamental wave oscillator circuit 31 and the fundamental wave oscillator circuit 31 is connected to the frequency measurement unit 20; a state where this first electrode 4 is connected to the third harmonic oscillator circuit 32 and the third harmonic oscillator circuit 32 is connected to the frequency measurement unit 20; a state where the second electrode 5 on the one surface side of the crystal element 14 is connected to the fundamental wave oscillator circuit 31 and the fundamental wave oscillator circuit 31 is connected to the frequency measurement unit 20; and a state where this second electrode 4 is connected to the third harmonic oscillator circuit 32 and the third harmonic oscillator circuit 32 is connected to the frequency measurement unit 20.

Therefore, the data processing unit 62 can identify that the frequency (frequency measurement value) as the measurement result measured by the frequency measurement unit 20 is the oscillation frequency corresponded to whether the first vibrating region 40 or the second vibrating region 50 by the switch signal, and this oscillation frequency is whether the fundamental wave or the third harmonic. Accordingly, the program writes the frequency as the measurement result to the memory 64 with a distinction between the first vibrating region 40 and the second vibrating region 50 and a distinction between the fundamental wave and the third harmonic.

Then, the program includes a step of operating F2 - F1 based on the frequency of the fundamental wave and the frequency of the third harmonic in the first vibrating region 40 of the crystal resonator 11 thus written in chronological order, and obtaining the temperature from the operation result. The program further includes a step of monitoring whether F2 - F1 has an abnormal value or not, operating F2 - F1 based on the frequency of the fundamental wave and the frequency of the third harmonic in the second vibrating region 50 when the abnormal value is determined, and obtaining the temperature from the operation result. Therefore, a part of the program corresponds to a monitoring unit that monitors whether the first vibrating region 40 normally oscillates or becomes an abnormal state. To avoid confusion in the explanation, in this description, the frequency change rate of the fundamental wave in the first vibrating region 40 is F1, the frequency change rate of the third harmonic is F2, the frequency change rate of the fundamental wave in the second vibrating region 50 is F1', and the frequency change rate of the third harmonic is F2'.

A method for determining whether F2 - F1 has the abnormal value or not can include, for example, a method where a moving average in a predetermined time period is obtained for F2 - F1, and the abnormality is determined when an amount of change of the moving average in a certain time period (operation interval of moving average) exceeds a set amount in time-series data of the moving average. While this example is a method for determining the abnormality of the first vibrating region 40 based on F2 - F1, as the method for determining whether the first vibrating region 40 is abnormal or not, the moving average of F2 or F1 may be monitored, the amount of change of F2 or F1 in a unit time may be monitored, or the determination may be performed based on the frequencies of the fundamental wave and the third harmonic.

Next, the effects of the above-described embodiment will be described. The switch signal output unit 63 of the data processing unit 6 outputs the switch signal to specify switching states of the respective switches SW1, SW2, and SW3 via the signal path of the signal cable 3. This switches the switches SW1 to SW3 in order, for example, as <1> to <4>. For the explanation of switching, for convenience, the state of being switched to the switching contact ***a*** (*b*) side is described as that the switch SW is switched to the ***a* (*b*)** side.
<1> a state where the switch SW1 is switched to the ***a*** side, and the switches SW2 and SW3 are switched to the ***a*** side,
<2> a state where the switch SW1 is switched to the ***a*** side, and the switches SW2 and SW3 are switched to the *b* side,
<3> a state where the switch SW1 is switched to the *b* side, and the switches SW2 and SW3 are switched to the ***a*** side, and
<4> a state where the switch SW1 is switched to the ***b*** side, and the switches SW2 and SW3 are switched to the ***b*** side,

In a state of <1>, the frequency ***f1*** when the first vibrating region 40 is oscillated with the fundamental wave is measured, in a state of <2>, the frequency ***f2*** when the first vibrating region 40 is oscillated with the third harmonic is measured, in a state of <3>, the frequency ***f1'*** when the second vibrating region 50 is oscillated with the fundamental wave is measured, and in a state of <4>, the frequency ***f2'*** when the second vibrating region 50 is oscillated with the third harmonic is measured.

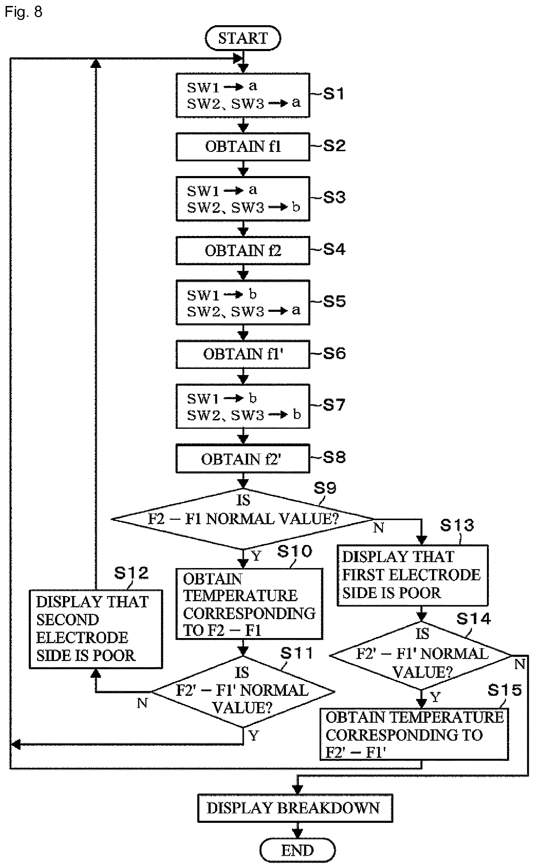

Step S1 to Step S8 in FIG. 8 indicate the relationship between the states of the switches SW1 to SW3 and the frequency measurement. As described above, since which oscillation frequency is the frequency to be measured is seen corresponding to the switch signal, the type of frequency (distinction of the oscillation frequency in which oscillation mode in which vibrating region) is matched to the measurement value of the frequency and stored in the memory 64, thus forming the time-series data. A time interval for switching the switches SW1 to SW3 is set to 250 ms, for example.

Then, the difference F2 - F1, which is the difference between the above-described frequency change rate (rate of change in frequency relative to the frequency at 25°C) F1 at the oscillation frequency ***f1*** of the fundamental wave in the first vibrating region 40 and the above-described frequency change rate F2 at the oscillation frequency *f2* of the third harmonic in the first vibrating region 40, is obtained, and this difference is determined whether a normal value or not (Step S9). This determination is performed to monitor the abnormality of the oscillation in the first vibrating region 40. As described above, the moving average of F2 - F1 from the determination point to a time point going back by a predetermined period (predetermined sampling number) is compared with the moving average from the time point going back from the determination point by the predetermined period to a time point further going back by a predetermined period, and when the comparison result (difference) exceeds the set value, the abnormality is determined.

When F2 - F1 is normal, the temperature corresponding to F2 - F1 is obtained based on temperature characteristics data, for example, preliminarily illustrated in FIG. 7 (Step S10), and displayed on the display unit 65. Subsequently, the difference F2'-F1', which is the difference between the above-described frequency change rate F1' at the oscillation frequency ***f1'*** of the fundamental wave in the second vibrating region 50 and the above-described frequency change rate F2' at the oscillation frequency ***f2'*** of the third harmonic in the second vibrating region 50, is obtained, and this difference is determined whether a normal value or not (Step S11). This determination is performed with a method similar to the above-described determination of F2 - F1. After that, while the process returns to Step S1, when F2' - F1' is determined to be abnormal, the display unit 65 displays that the second vibrating region 50 is poor on an area other than the temperature display area (Step S12).

Meanwhile, when F2 - F1 is determined to be abnormal at Step S9, it is displayed that the first vibrating region 40 is poor (Step S13). In this case, while the temperature detection is performed based on the oscillation frequency of the second vibrating region 50, that is, based on F2' - F1', the determination whether F2' - F1' is normal or not is performed to make sure as described above (Step S14). When F2' - F1' is normal, the temperature is obtained using data on the relationship between the temperature stored in the memory in advance and F2' - F1', and displayed on the display unit 65 (Step S15). When F2' - F1' is determined to be abnormal, it is notified that this temperature detector has broken down by, for example, displaying on the display unit 65 (Step S15).

In the above-described embodiment, the crystal element 14 includes the first and the second vibrating regions 40 and 50, the respective frequency change rates F2 and F1 when the first vibrating region 40 as one vibrating region is oscillated with the third harmonic and the fundamental wave are obtained, and the difference between them is used to detect the temperature of the atmosphere where the crystal element 14 is placed. Then, on the basis of the measurement result of the frequency of the first vibrating region 40, whether the oscillation in this first vibrating region 40 is abnormal or not is monitored. When the abnormality is determined, the second vibrating region 50 is used to detect the temperature from the similar difference (F2' - F1').

While, when the temperature is detected over a temperature range, the frequency jump possibly occurs especially on a high temperature side or a low temperature side, the temperature detection can be performed using the second vibrating region 50 even if a failure occurs in the first vibrating region 40, thus eliminating the possibility of interruption in the temperature detection.

As Steps S12 and S13, displaying the occurrence of the abnormality in one of the first and the second vibrating regions 40 and 50 ensures an operator to take measures by, for example, replacing the crystal resonator 11 at a timing of a break of the temperature detection operation.

The switch that connects the respective vibrating regions 40 and 50 to the frequency measurement unit 20 via the fundamental wave oscillator circuit 31 or the third harmonic oscillator circuit 32 is not limited to the example illustrated in FIG. 5. For example, a configuration may be employed such that the fundamental wave oscillator circuit and the third harmonic oscillator circuit are partially shared while a tuned circuit for the fundamental wave and a tuned circuit for the third harmonic are switched so as to provide the function of the fundamental wave oscillator circuit or the third harmonic oscillator circuit. In this case, a switch that switches a front stage of the shared circuit to one or the other of the first vibrating region 40 and the second vibrating region 50, and a switch for switching the tuned circuits are used.

While the above-described embodiment exemplified the case where the higher harmonic is the third harmonic in obtaining the difference between the frequency change rate of the higher harmonic of the crystal resonator and the frequency change rate of the fundamental wave, the higher harmonic is not limited to the third harmonic, but, for example, a fifth harmonic (fifth higher harmonic) may be employed.

### DESCRIPTION OF REFERENCE SIGNS

- 1: ... oscillator circuit unit
- 10: ... resonator unit
- 11: ... crystal resonator
- 12: ... circuit board
- 13: ... opening
- 14: ... crystal element
- 15: ... other-surface-side electrode
- 2: ... measurement unit
- 20: ... frequency measurement unit
- 3: ... signal cable
- 31: ... fundamental wave oscillator circuit
- 32: ... third harmonic oscillator circuit
- 4: ... first electrode
- 40: ... first vibrating region
- 5: ... second electrode
- 50: ... second vibrating region
- SW1 to SW3: ... switch
- 6: ... data processing unit
- 65: ... display unit

## Claims

1. A temperature detector comprising:
a first vibrating region sandwiched between first electrodes, the respective first electrodes being disposed on one surface side and another surface side of a crystal element;
a second vibrating region sandwiched between second electrodes, the respective second electrodes being disposed on the one surface side and the other surface side of the crystal element;
a fundamental wave oscillator circuit that oscillates the first vibrating region or the second vibrating region with a fundamental wave;
a harmonic oscillator circuit that oscillates the first vibrating region or the second vibrating region with a higher harmonic;
a frequency measurement unit that measures an oscillation frequency of the fundamental wave oscillator circuit or the harmonic oscillator circuit;
a switch for selecting any of states, the states including a state where the first electrodes are connected to the frequency measurement unit via the fundamental wave oscillator circuit, a state where the first electrodes are connected to the frequency measurement unit via the harmonic oscillator circuit, a state where the second electrodes are connected to the frequency measurement unit via the fundamental wave oscillator circuit, and a state where the second electrodes are connected to the frequency measurement unit via the harmonic oscillator circuit; and
a data processing unit for: outputting a switch signal of the switch; obtaining a difference between a frequency change rate of the higher harmonic in one vibrating region of the first vibrating region and the second vibrating region and a frequency change rate of the fundamental wave of the one vibrating region based on measurement result measured by the frequency measurement unit; and detecting a temperature of an atmosphere from the difference, the crystal element being placed in the atmosphere, the data processing unit monitoring whether the oscillation of the one vibrating region is abnormal or not based on the measurement result of the frequency of the one vibrating region, wherein
the data processing unit is configured such that the data processing unit detects the temperature of the atmosphere where the crystal element is placed from a difference between a frequency change rate of the higher harmonic in another vibrating region of the first vibrating region and the second vibrating region and a frequency change rate of the fundamental wave of the other vibrating region when the oscillation of the one vibrating region is determined to be abnormal.

2. The temperature detector according to claim 1, wherein
the higher harmonic is a third higher harmonic.

3. The temperature detector according to claim 1, wherein
the monitoring of whether the oscillation of the one vibrating region is abnormal or not is performed based on a value of a moving average of any of the frequency change rate of the higher harmonic, the frequency change rate of the fundamental wave, and the difference.

4. The temperature detector according to claim 1, wherein
the first vibrating region and the second vibrating region are formed on a common crystal element.
